# FASCICULE DE BREVET EUROPEEN

(11) **EP 0 370 898 B1**
(45) Date de publication et mention de la délivrance du brevet: **29.06.1994**
(21) Numéro de dépôt: 89403212.7
(22) Date de dépôt: 21.11.1989
(51) Int. Cl.: H01P 1/30, H05K 3/28

(54) **Ligne triplaque perfectionnée**
Triplate-Streifenleitung
Triplate line

(30) Priorité: 23.11.1988 FR 8815271
(43) Date de publication de la demande: 30.05.1990
(73) Titulaire: COMMISSARIAT A L'ENERGIE ATOMIQUE, 75015 Paris Cédex 15 (FR)
(72) Inventeur: Beauferey, Jean-François, F-51000 Reims (FR); Herbert, Rémy, F-77100 Meaux (FR); Reynier; Patrick, F-37700 Saint Pierre Des Corps (FR)
(74) Mandataire: Signore, Robert

(56) Documents cités:
- EP-A- 0 016 952
- FR-A- 2 118 246
- FR-A- 2 551 618
- US-A- 4 707 671

## Description

La présente invention a pour objet une ligne triplaque perfectionnée.

Son domaine d'application est celui de l'électronique.

Les circuits imprimés connus comprennent, de manière classique, un ou plusieurs conducteurs déposés sur un ou plusieurs films isolants diélectriques (circuit dit multicouches). Le métal utilisé est le plus souvent le cuivre et les isolants appartiennent à la famille qui comprend les polyimides, le polytétrafluoroéthylène, les époxydes, les polyesters, les fluorocarbones, les polysulfones, le polyéthersulfone, le polyétherétherkétone.

On peut trouver une description de ces circuits par exemple dans FR-A-2 118 246 ; FR-A-2 551 618 et US-A-3,244,795.

Si ces circuits imprimés présentent de nombreux avantages et ont donc connu un remarquable essor ces dernières années, ils présentent néanmoins quelques inconvénients, notamment une faible résistance aux rayonnements, une sensibilité à l'humidité et à certains produits chimiques, etc., ce qui les rend peu aptes aux applications en environnement agressif. Par ailleurs, leur rigidité empêche de les utiliser dans certaines applications où la ligne doit être pliée pour éviter un encombrement excessif.

Le but de la présente invention est justement de remédier à ces inconvénients. A cette fin, l'invention propose une ligne triplaque offrant une excellente résistance aux rayonnements, n'absorbant pas l'humidité, présentant une inertie chimique remarquable à l'égard des solvants, des acides, des hydrocarbures, etc. et offrant en outre une certaine souplesse, toutes caractéristiques qui confèrent au circuit de l'invention de nombreux avantages.

Ce résultat est atteint grâce à l'utilisation, pour constituer au moins les deux films diélectriques disposés à la surface extérieure de la ligne, d'un matériau diélectrique souple chargé par une trame de verre. La qualité de la trame de verre permet également de réduire notablement l'épaisseur des isolants, ce qui contribue encore à améliorer la souplesse de l'ensemble.

Naturellement, on peut charger d'une trame de verre également les films internes au circuit, si besoin est.

De façon plus précise, la présente invention a donc pour objet une ligne triplaque comprenant un conducteur intérieur plat intercalé entre deux conducteurs extérieurs plats, des films isolants disposés entre le conducteur intérieur et chaque conducteur extérieur, et deux films diélectriques extérieurs recouvrant les conducteurs extérieurs, cette ligne étant caractérisée par le fait qu'au moins les films diélectriques extérieurs sont constitués par une résine souple chargée par une trame de verre, la ligne étant alors souple.

Pour ce qui est des matériaux utilisables, tous les matériaux diélectriques connus à ce jour ou à venir, et réputés aptes à être utilisés dans les circuits imprimés multicouches sont utilisables et, notamment, ceux qui ont été énumérés plus haut, sauf les résines époxy qui entraîneraient une rigidité de la ligne.

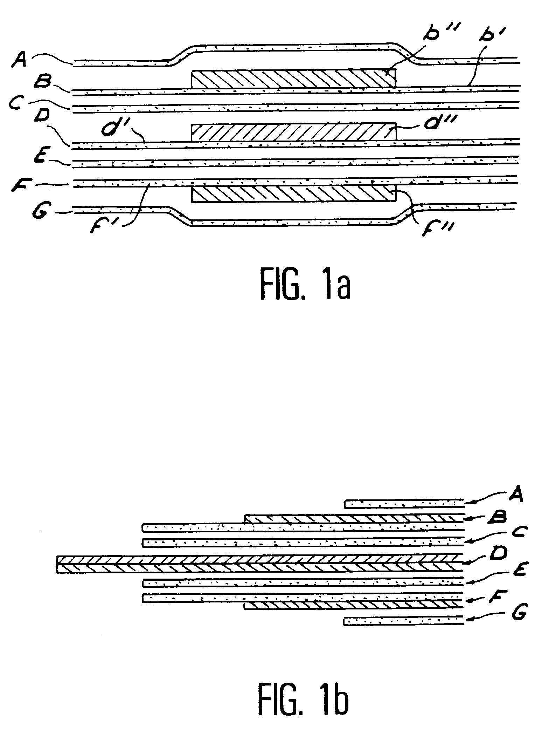

De toute façon, les caractéristiques et avantages de l'invention apparaîtront mieux après la description qui va suivre, d'exemples de réalisation donnés à titre explicatif et nullement limitatif. Cette description se réfère à une figure unique annexée qui représente un mode de réalisation de l'invention.

La partie (a) de la figure représente la ligne triplaque vue en coupe transversale et la partie (b) cette même ligne vue en coupe longitudinale à l'extrémité de la ligne. Cette dernière vue permet d'illustrer le dégagement des divers conducteurs pour permettre le raccordement à un connecteur électrique (non représenté).

La ligne illustrée comprend successivement :
- une couche A supérieure en matériau diélectrique chargé par une trame de verre,
- une couche B formée par une couche diélectrique b′ sur laquelle adhère une première microplaque métallique b˝,
- une couche C d'un matériau adhésif,
- une couche D comprenant une couche diélectrique d′ sur laquelle adhère une deuxième microplaque de métal d˝,
- une couche E d'adhésif,
- une couche F fournie d'une couche diélectrique f′ avec une troisième microplaque f˝,
- une couche inférieure G en matériau diélectrique chargé par une trame de verre.

Avec une telle ligne, le deuxième conducteur est généralement porté à une haute tension, le premier et le troisième étant portés à une basse tension, éventuellement la masse.

A titre explicatif, on peut indiquer que les matériaux suivants et les épaisseurs suivantes (exprimées en micromètres) peuvent être employés : couches A, G :
i) résine fluorocarbone : polytétrafluoroéthylène (PTFE)
   ou éthylènepropylènefluor (FEP)
   ou copolymère composé de la chaîne principale carbone fluor à laquelle sont liées des chaînes latérales (PFA)
ii) polyétherétherkétone (PEEK)
   épaisseur : 25
   couches B, D et F : laminés polyimide cuivré,
   épaisseur du film : 20
   épaisseur du cuivre : 17,5 ou 35 ou 70
   couches C et E : adhésif époxy,
   épaisseur : 50
Avec des lignes triplaques de ce type, le demandeur a mesuré certaines caractéristiques électriques qui sont en moyenne les suivantes :
- capacité linéique : environ 800 pF/m,
- vitesse de propagation : environ 110 000 km/s à 30 MHz,
   environ 145 000 km/s à 270 MHz,
- impédance caractéristique : environ 10 Ω,
- résistance linéique de chaque conducteur en courant continu : 0,15 Ω/m.

Le procédé de réalisation d'une telle ligne est semblable aux procédés de l'art antérieur en ce qui concerne les couches B à F (non chargées). On peut utiliser des produits en rouleau, par exemple ceux de la Société FORTIN LAMINATING et notamment la série POLY COAT EP (film kapton adhésif époxy), POLY CORE EP (kapton cuivré adhésif époxy), POLY CAST EC (film adhésif).

La pression à appliquer est de l'ordre de 7 kg/cm² et la température de l'ordre de 171°C, le tout à appliquer pendant 60 minutes, avec température de refroidissement de 60°C avant ouverture de la presse.

Pour ce qui est de l'obtention des couches A et G en diélectrique chargé d'une trame de verre, on peut s'y prendre par pression entre 10 et 20 kg/cm² à une température supérieure à 220°C.

La ligne peut finalement être recouverte, sur l'une ou l'autre de ses faces extérieures, d'une couche d'adhésif.

## Revendications

1. Ligne triplaque comprenant un conducteur intérieur plat (d˝) intercalé entre deux conducteurs extérieurs plats (b˝, f˝), des films isolants (C, E, f′, d′, b′) disposés entre le conducteur intérieur (d˝) et chaque conducteur extérieur (b˝, f˝), et deux films diélectriques extérieurs (A, G) recouvrant les conducteurs extérieurs (b˝, f˝), caractérisée par le fait qu'au moins les films diélectriques extérieurs (A, B) sont constitués par une résine souple chargée par une trame de verre, la ligne étant alors souple.

2. Ligne triplaque, caractérisée par le fait que la résine souple est en résine fluorocarbone (PTFE, FEP, PFA) ou en polyétherétherkétone (PEEK).

## Claims

1. Triple-plate line comprising a flat inner conductor (d") sandwiched between two flat outer conductors (b", f"), insulating films (C, E, f', d', b') arranged between the inner conductor (d") and each outer conductor (b", f"), and two outer dielectric films (A, G) covering the outer conductors (b", f"), characterized in that at least the outer dielectric films (A, G) are constituted by a flexible resin filled with a glass weft, the line then being flexible.

2. Triple-plate line, characterized in that the flexible resin is made of fluorocarbon resin (PTFE, FEP, PFA) or made of polyetheretherketone (PEEK).

## Patentansprüche

1. Triplate-Streifenleitung, umfassend einen flachen Innenleiter (d''), eingefügt zwischen zwei flache Außenleiter (b'', f''), Isolierfilme (C, E, f', d', b'), angeordnet zwischen dem Innenleiter (d'') und jedem Außenleiter (b'', f''), und zwei dielektrische Außenfilme (A, G), die die Außenleiter (b'', f'') überdecken,
**dadurch gekennzeichnet,**
daß wenigstens die dielektrischen Außenfilme (A, B) gebildet werden durch ein biegsames Harz, verstärkt durch einen Glaseintrag, wobei die Leitung somit biegsam ist.

2. Triplate-Streifenleitung, dadurch gekennzeichnet, daß das biegsame Harz aus Fluorkohlenstoffharz (PTFE, FEP, PFA) oder aus Polyetheretherketon (PEEK) ist.
